# EUROPEAN PATENT SPECIFICATION

(11) **EP 3 767 664 B1**
(45) Date of publication and mention of the grant of the patent: **28.08.2024**
(21) Application number: 19186997.3
(22) Date of filing: 18.07.2019
(51) Int. Cl.: H01L 21/033, H01L 21/8234, H01L 29/66

(54) **SELF-ALIGNED LAYER PATTERNING**
SELBSTJUSTIERTE SCHICHTSTRUKTURIERUNG
FORMATION DE MOTIFS AUTO-ALIGNÉS DANS DES COUCHES

(43) Date of publication of application: 20.01.2021
(73) Proprietor: Imec VZW, 3001 Leuven (BE)
(72) Inventor: CHAN, Boon Teik, 3001 Leuven (BE); SIEW, Yong Kong, 3001 Leuven (BE); BOEMMELS, Juergen, 3001 Leuven (BE)
(74) Representative: Winger

(56) References cited:
- US-A1- 2016 254 191
- US-A1- 2019 097 023
- US-A1- 2019 122 934
- US-A1- 2019 123 189

## Description

### Technical field of the invention

The present invention relates to field of layer patterning and more in particular to the patterning of parallel lines in a semiconductor material, especially for the formation of Fin Field Effect Transistor (FinFET) gates.

### Background of the invention

When a pattern of parallel lines in a semiconductor material is desired, the typical procedure has traditionally been to cover the semiconductor with a hard mask, to form parallel lines of a photoresist material by lithography on the hard mask, then to transfer these lines in the hard mask and ultimately in the semiconductor material.

For instance, this process permits to form lines of 42 nm width separated by spaces of 42 nm width. However, forming lines of smaller width is beyond the capability of current lithographic processes. In order to increase the density of lines, one can use a line multiplication process such as SAMP (self-aligned multiple patterning). The simplest SAMP process is SADP (self-aligned double patterning). In a typical SADP process, each line of the lithographically printed pattern will serve as a core or mandrel on which a hard mask spacer will be deposited. The hard mask spacer is present on the sidewalls and on the top of the mandrels. The hard mask spacers are then etched back until the top of the mandrels are exposed. The mandrels can then be removed by etching, leaving a pattern formed by the hard mask spacers. This pattern can then be transferred in the in the underlying layer. This pattern will have a pitch which is twice smaller than the pitch of the lithographically printed pattern. The density of lines as thereby been doubled. In our example, the lines and the spaces between them are now each 21 nm wide. Although SAMP is performed routinely today, the standard SAMP procedures form lines having the same width as the spaces between them. This feature is however not always desired. There is therefore a need in the art for methods enabling the formation of lines wider than the space between them at a pitch which is not accessible by direct lithography.

An example of a method of patterning a semiconductor material can be found in US 2016/254191 A. The fabrication method involves forming first spacers over a substrate, and depositing a second spacer on sidewalls of each first spacers. A third spacer is formed on each opposing sidewall of the second spacer, and a first etch process is performed on the substrate to form fin regions within the substrate, in which the third spacers mask portions of the substrate during the first etch process. The fin region width is substantially equal to about the third spacer width.

### Summary of the invention

It is an object of the present invention to provide good methods for patterning a layer.

In a first aspect, the present invention relates to a method according to claim 1.

This first aspect of the present invention provides a procedure enabling the formation of lines wider than the space between them at a pitch which is not accessible by direct lithography. In the example introduced in the background section, this can translate into a pitch remaining at 42 nm but wherein the lines are wider than 21 nm (e.g. 28 nm) while the spaces between them are narrower than 21 nm (e.g. 14 nm).

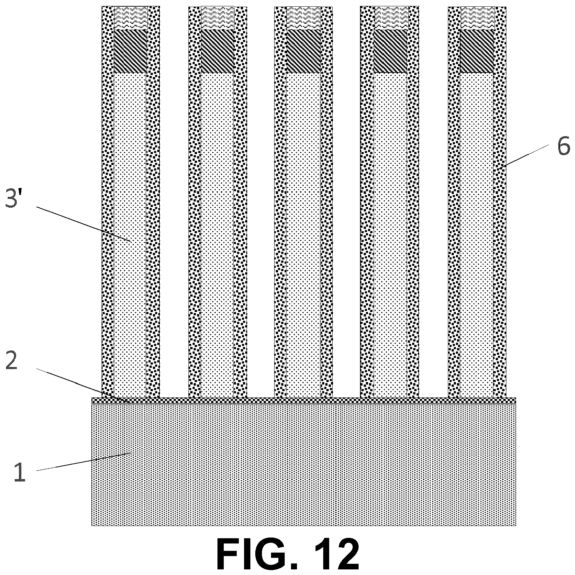

The formation of a FinFET entails the formation of a semiconductor fin and of a gate covering sides of part of the fin. The part of the fin covered by the gate will act as the channel and the gate will be used to control the current flowing through that channel. The formation of the gate is typically done by a replacement metal gate (RMG) process involving the formation of a dummy gate in the early stages of the process and its replacement by the actual gate stack at the end of the process. The dummy gate is a sacrificial structure aimed at occupying the place that will ultimately be occupied by the actual gate stack. The dummy gate is typically formed of polysilicon. As is depicted in Fig. 12, the dummy gate (3') is typically protected by a hard mask on top of the dummy gate, and gate spacers (6) covering the sides of the dummy gate and of the hard mask. The hard mask protects the dummy gate from the top during etching steps used during the early stages of the RMG process, and the gate spacers protect the dummy gate from the sides during said early stages while simultaneously delimiting the lateral extent of the future actual gate. Today, in order to form these dummy gates, SAMP line multiplication processes are used to achieve a gate width smaller than what can be achieved by lithography alone.

At the end of the dummy gate patterning, the desired gate width may be smaller than the width achieved by the SAMP process used. For instance, the SAMP process may form 21 nm dummy gate lines with a 42 nm pitch while 16 nm dummy gate lines would be desired for this same 42 nm pitch. Hence, a trimming of the dummy gate lines is typically performed. Once this trimming is performed, as depicted in Fig. 12, the sidewalls of the trimmed dummy gate lines (3') and of the hard mask thereon are coated with the gate spacer (6). For instance, 6 nm of gate spacer may be present on each side of each line. The width of the trimmed line-spacer assembly would in this case be 28 nm.

In the early stages of the RMG process, the part of the fin not covered by the dummy gate, on either side of the gate, will be used to form the source and the drain of the FinFET. Source and drains are typically formed by epitaxial growth of a semiconductor on parts of the fin not covered by the dummy gate.

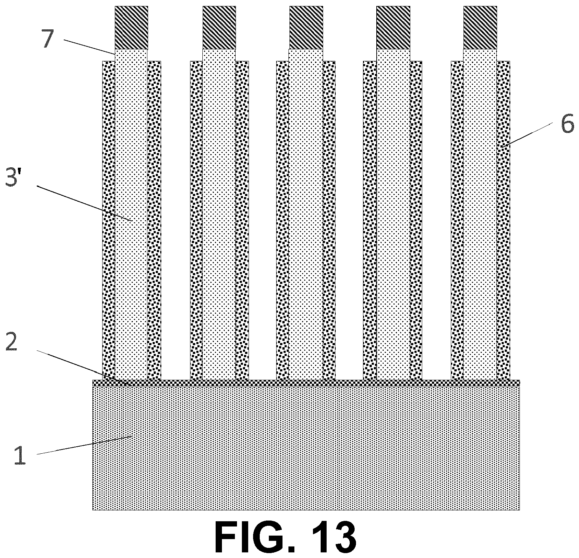

Prior to this epitaxial growth, it can be advantageous to reduce the height of these uncovered parts of the fin. This is especially true when the fins are very high as, for instance, in the case of the complementary field effect (CFET) technology. In CFET, the state of the art is to have fins of about 80 nm high. Epitaxially growing sources and drain on such high fin parts is problematic. It is advantageous to reduce the height of the uncovered fin parts to a large extent prior to epitaxially grow the source and drains therefrom. As a result, in the case of a 80 nm fin, a bit less than 80 nm of the uncovered fin parts will be recessed. It is desirable that the dummy gate remains covered on all sides after the recessing of the uncovered fin parts. If it were not the case, the subsequent step of epitaxially growing the source and the drain would lead to parasitic epitaxial growth on the exposed dummy gates. In order to achieve an adequate protection of the dummy gate, the hard mask height is typically chosen to be high enough so that it is not entirely consumed before the uncovered fin parts are recessed. As depicted in Fig. 13, a problem with the current approach is that the gate spacers (6) are exposed to the etchant and are therefore consumed during the recessing of the uncovered fin parts. This can easily lead to the sidewalls (7) of the dummy gate (3') becoming exposed during the recessing of the uncovered fin parts.

The present inventors have found that one possible solution to this problem would be to protect from the top the gate spacers with the hard mask, i.e. to have the hard mask lines wider than the dummy gate lines so that the hard mask lines would be wide enough to cover at least part of the gate spacers lining the dummy gate lines. However, in order to keep both the pitch (e.g. 42 nm) and the dummy gate lines width (e.g. 16 nm) unchanged, this requires that the hard mask lines be wider than the space between them. This is a situation where the first aspect of the present invention can for instance be used.

The present inventors have realized that by skipping the mandrel removal step in a SAMP process, lines thicker than the spaces between them can be obtained. In other words, instead of removing the mandrels prior to the transfer of the hard mask pattern in the semiconductor material, the mandrels are left in place and the whole assembly hard mask spacers-mandrel is transferred instead. As a result, lines thicker than the spaces between them can be formed in the semiconductor material, the dimensions of which being smaller than what can be achieved by lithography alone.

An advantage of embodiments of the first aspect of the present invention is that dummy gate lines of more uniform thickness can be obtained than in the prior art. This also means that less unwanted etching of the dummy gates occurs. In embodiments, about 50% less of the dummy gate is etched away, compared to the prior art.

Without being bound by theory, it is believed that this more uniform thickness of the dummy gate lines is due to the smaller space between the hard mask lines.

Another advantage of embodiments of the first aspect of the present invention is that it permits the formation of taller gates than in the prior art. In the prior art, the irregular profile of the dummy gate lines limits the dummy gate height that can be achieved. This is much less the case in the embodiments of the present invention. Also, the risk of dummy gate line collapse is reduced when compared to the prior art.

It is yet another advantage of embodiments of the first aspect that they adapt existing SAMP procedures which are already well established in the field of semiconductor processing.

In a second aspect, the present invention relates to an intermediate structure in the formation of a Fin-based Field Effect Transistor according to claim 14.

The above objective is accomplished by a method and intermediate structure according to the present invention.

Particular and preferred aspects of the invention are set out in the accompanying independent and dependent claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. The reference figures quoted below refer to the attached drawings.

### Brief description of the drawings

Figs. 1, 3, 5, 6, 9, 10, and 11 are schematic representation of vertical cross-sections through intermediate structures obtained after various steps of an embodiment of the first aspect of the present invention.
Figs. 2, 4 and 7 are images obtained by top down Critical Dimension Scanning Electron Microscopy of intermediate structures obtained experimentally and corresponding to the stages illustrated in Figs. 1, 3, and 6 respectively.
Fig. 8 is an image obtained by cross-sectional Scanning Electron Microscopy of a vertical cross-sectional view of an intermediate structure obtained experimentally and corresponding to the stage illustrated in Fig. 6.
Figs. 12 and 13 are schematic representation of vertical cross-sections through intermediate structures obtained after various steps of a process of the prior art.

In the different figures, the same reference signs refer to the same or analogous elements.

### Description of illustrative embodiments

The present invention will be described with respect to particular embodiments and with reference to the drawings. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method.

In the description provided herein, numerous specific details are set forth. However, it is understood that embodiments of the invention may be practiced by means of well-known methods, structures and techniques, which have not been shown in detail in order not to obscure an understanding of this description.

Reference will be made to transistors. These are three-terminal devices having a first main electrode such as a drain, a second main electrode such as a source and a control electrode such as a gate for controlling the flow of electrical charges between the first and second main electrodes.

In step a of the method according to the present invention, SAMP can be used to form a first pattern of regularly spaced mandrels on the layer to be patterned.

SAMP (not depicted) typically comprises forming a pattern of regularly spaced first elements on a layer to be patterned, forming hard mask spacers on sidewalls of these first elements, removing the first elements, thereby leaving a pattern of spacers, and transferring the pattern of spacers in the layer to be patterned, thereby forming a pattern of regularly spaced second elements (corresponding to the mandrels formed in step a). In SADP, the first elements are formed directly by lithography, i.e. by transferring a photoresist pattern in a hardmask. In SAQP, the first elements are the second elements formed by SADP.

In general, if SADP is considered as an SAMP of order 1, SAQP is considered as an SAMP of order 2, etc..., for an SAMP of order n+1, the first elements are the second elements formed by an SAMP of order n.

The shape of each element is preferably the same.

In embodiments, the shape of each mandrel is preferably the same.

The elements are typically lines. As a result, in embodiments, the mandrels are typically lines.

The first pattern is typically formed of parallel lines.

In embodiments, each mandrel forming the pattern may have a width of at most 40 nm. For instance, they may have a width of from 1 to 40 nm.

Preferably, they may have a width of from 1 to 30 nm. More preferably from 1 to 25 nm. Typically, from 12 to 25 nm.

The widths of the mandrels are preferably within 10%, more preferably within 5% of one another. Most preferably, they are the same.

In embodiments, the height of the mandrels may be from 1.5 to 10 times, preferably from 3 to 6 times, more preferably from 4 to 5 times the width of the mandrels.

The heights of the mandrels are preferably within 10%, more preferably within 5% of one another. Most preferably, they are the same.

The mandrels are separated by spaces. The widths of the spaces are preferably within 10%, more preferably within 5% of one another. Most preferably, they are the same.

The average width of the spaces is preferably within 10%, more preferably within 5% of the average width of the mandrels. Preferably the average width of the spaces is the same as the average width of the mandrels.

In embodiments, the widths of the mandrels may be within 10% of one another, wherein the widths of the spaces between the mandrels are within 10% of one another and wherein the average mandrel width is within 10% of the average space width.

In embodiments, the mandrels may comprise a bottom layer made of a first material and a top layer made of a second material.

In embodiments, the bottom layer may be made of silicon nitride or silicon carbide and the top layer may be made of silicon oxide.

In embodiments, the height of the bottom layer may be from 0.7 to 4.5, preferably 1.5 to 2.5 times the width of the mandrels.

In embodiments, the height of the top layer may be from 0.8 to 5.5, preferably 2 to 3 times the width of the mandrels.

In embodiments, the layer to be patterned in step a may be a layer of semiconductor material. For instance, it may be polycrystalline silicon or amorphous silicon.

Typically, the material of the layer to be patterned is selected in such a way that it can be etched selectively with respect to the material(s) forming the mandrels and the spacers.

In embodiments, the thickness of the layer to be patterned may be from 5 times to 15 times, preferably from 7 times to 13 times the width of the mandrels.

In embodiments, the thickness of the layer to be patterned may be from 100 to 350 nm, preferably from 150 to 300 nm.

In step b of the method according to the present invention, forming hard mask spacers on sidewalls of the mandrels may comprise a step b1 of forming a conformal layer of spacer material over the mandrels, thereby lining the top and the sidewalls of the mandrels, then a step b2 of etching part of the spacer material so as to expose the top of the mandrels while keeping the sidewalls of the mandrels covered.

The material of the hard mask spacers may for instance be an oxide, a nitride, a carbide, a carbonitride, an oxycarbonitride, an oxynitride, or an oxycarbide of silicon. It is typically an oxide of silicon since the polycrystalline silicon typically used for the layer to be patterned shows a higher etching selectivity with respect to oxides of silicon than with respect to the nitrides or carbides.

The result of step b is the formation of a second pattern formed of assemblies comprising a mandrel and hard mask spacers.

The assemblies are wider than the space between them.

In embodiments, the assemblies may be separated by spaces and the assemblies may have an average width at least 50% larger than the width of the spaces between them.

In step c of the method according to the present invention, the second pattern is etched in the layer to be patterned.

Although the method of the first aspect can find various applications, it is particularly useful for forming a pattern of dummy gates during the manufacture of a semiconductor device, wherein the layer to be patterned is a layer of dummy gate material. In this case, step c results in the formation of a pattern of dummy gate etched in the layer of dummy gate material.

In such a case, the intermediate structure resulting from step c may be obtained. Preferably, the width of the assembly is within 2% of the width of the dummy gate. Preferably, these widths are the same.

When the method aims at forming a pattern of dummy gates, the method may further comprise a step d, after step c, of reducing the width of the dummy gates. The width of the dummy gate may for instance be reduce by 25 to 40%, for instance by 30 to 35%. After the trimming, the assemblies are wider than the dummy gate lines. The method may further comprise a step e, after step d, of forming gate spacers on sidewalls of the dummy gates.

In embodiments, the assemblies are wide enough to cover at least part of the gate spacers lining the dummy gate lines.

In embodiments, step e may comprise a step e1 of forming a gate spacer on the sidewalls of the dummy gates and on the sidewalls of the hard mask spacers, and a step e2 of etching selectively the gate spacer present on the sidewalls of the hard mask spacers with respect to the gate spacers present on the sidewalls of the dummy gates. Step e1 may for instance be performed by ALD. Step e2 operates while the gate spacer present on the sidewalls of the dummy gate is protected by the assembly.

In embodiments, the material of the gate spacers may be different from the material of the hard mask spacers. Examples of suitable materials for the gate spacer are Silicon nitride and silicon oxycarbide, amongst others.

In embodiments, the layer of dummy gate material may be over a semiconductor fin, and the method may further comprise:
- a step f, after step e, of etching a part of the semiconductor fin which is not covered by the dummy gates, thereby reducing the height of the semiconductor fin, and
- a step g, after step f, of epitaxially growing a source or a drain on the etched part of the semiconductor fin.

In embodiments, the height of the semiconductor fin may be at least 70 nm.

Any feature of the first aspect may be as correspondingly described in any embodiment of the second aspect.

In a second aspect, the present invention relates to an intermediate structure in the formation of a Fin-based Field Effect Transistor according to claim 14.

In embodiments, the dummy gate has a first width measured at 10% of its height, and a second width measured at 90% of its height, and wherein the first width and the second width are within 10% of one another.

Any feature of the second aspect may be as correspondingly described in any embodiment of the first aspect.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

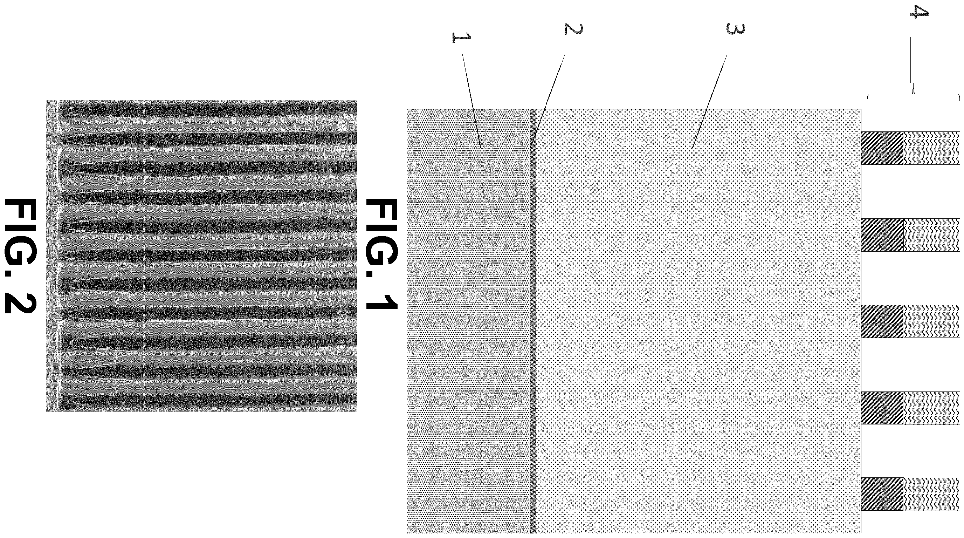

We now refer to Fig.1 and 2.

Fig. 1 shows a simplified schematic vertical cross-section of a semiconductor structure. Present but not depicted in this cross-section is a silicon substrate comprising a plurality of 80 nm high, 6 nm wide fins at a 25 nm pitch. Depicted are a shallow trench isolation (1) made of a silicon oxide, a 2 nm silicon oxide (2) deposited by plasma-enhanced atomic layer deposition (PEALD) on the shallow trench isolation, a layer (3) to be patterned on the PEALD silicon oxide, and a first pattern, formed by SADP, of regularly spaced mandrels (4) on the layer (3). This layer (3) was in this instance made of polycrystalline silicon and was 200 nm thick. The mandrels are made of a bottom 40 nm Si₃N₄ layer and a top 50 nm SiO₂ layer. The mandrels are spaced at a pitch of 42 nm and have a width of 21 nm. Fig. 2 is a top view obtained by top down Critical Dimension Scanning Electron Microscopy of this structure.

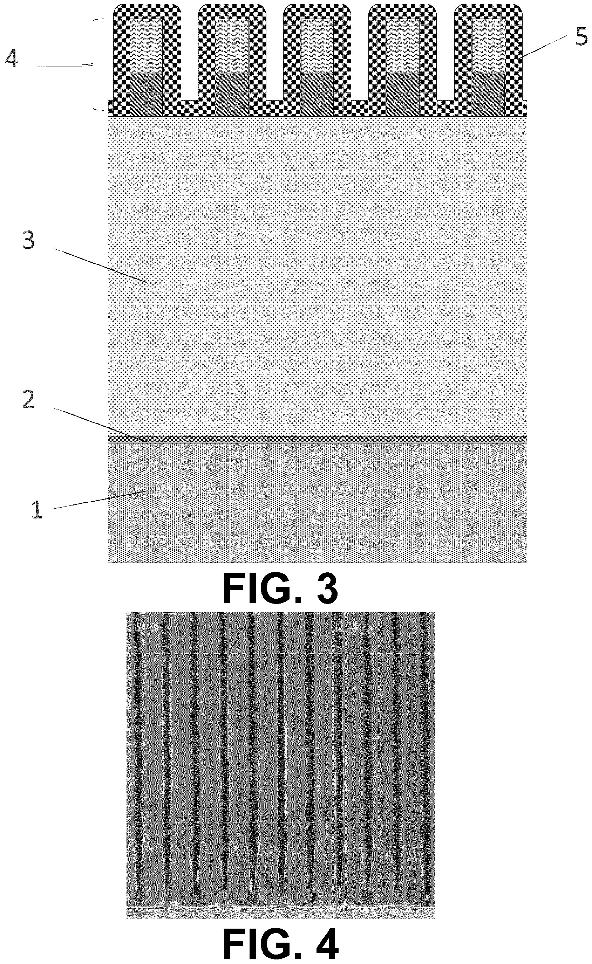

In Fig. 3, a layer (5) of SiO₂ has been applied on the mandrels and is therefore present on the top and the sidewalls of the mandrels. Fig. 4 shows a top view obtained by top down Critical Dimension Scanning Electron Microscopy of this structure.

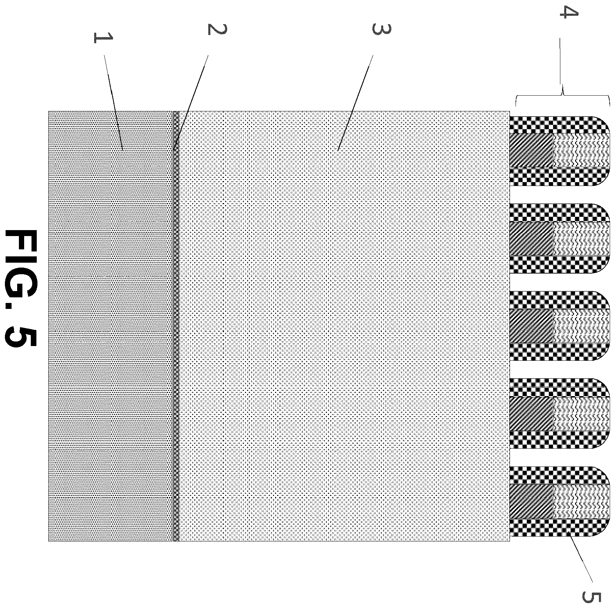

In Fig. 5, the SiO₂ layer (5) has been etched until the top of the mandrels was exposed. The assembly composed of the mandrel and the hard mask is wider than the space between them.

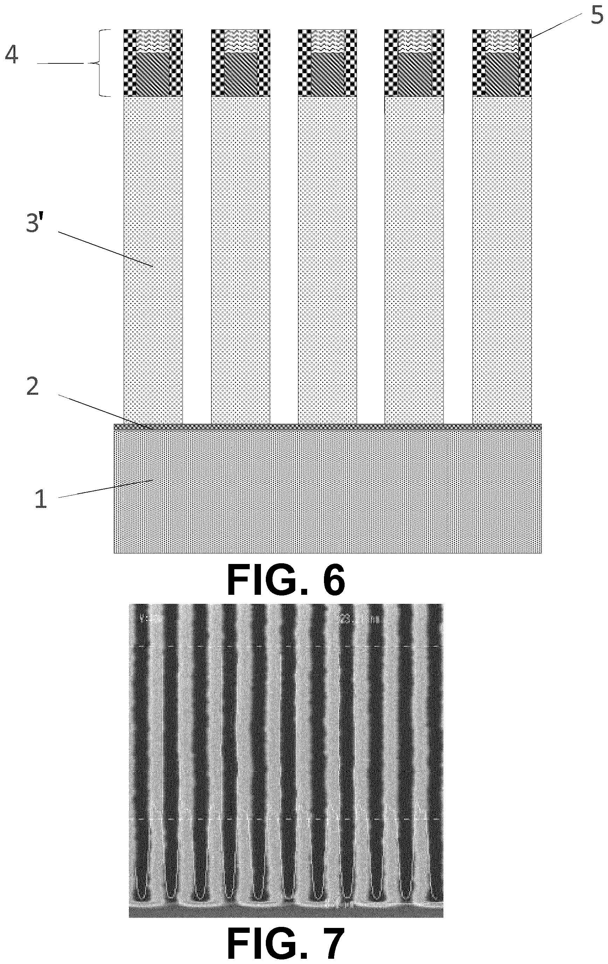

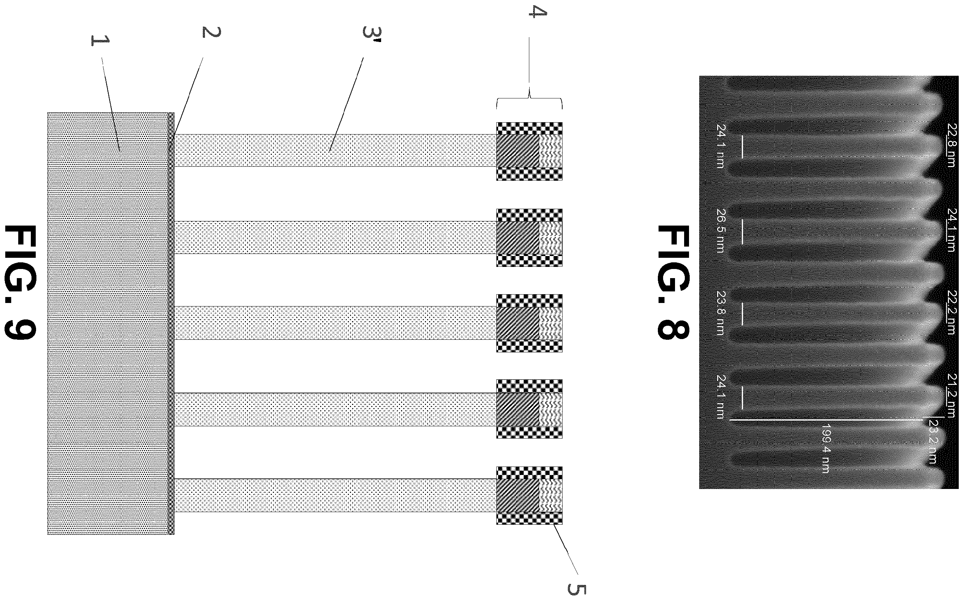

In Fig. 6, the assembly composed of the mandrel and the hard mask spacers have been used as a mask to etch the layer to be patterned, thereby forming dummy gates which are wider than the spaces between them. The pitch remains the same as in Fig. 1 and 2. Fig. 7 shows a top view obtained by top down Critical Dimension Scanning Electron Microscopy of this structure. Fig. 8 shows a vertical cross-section micrograph of this structure obtained by cross-sectional Scanning Electron Microscopy.

In Fig. 9, the dummy gates have been trimmed to reduce their width from more than 24 nm to about 16 nm.

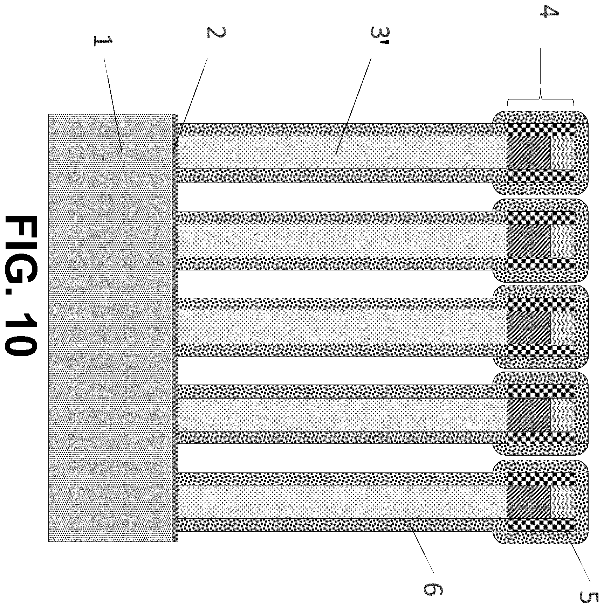

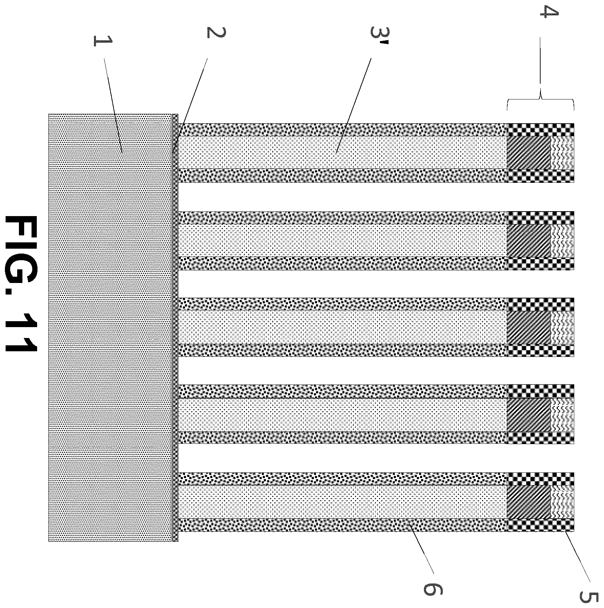

In Fig. 10, a silicon nitride gate spacer (6) has been deposited conformally by ALD on the dummy gates and the assemblies. Next, in Fig. 11, the gate spacer present on the sidewalls of the hard mask spacers was etched selectively with respect to the gate spacers present on the sidewalls of the dummy gates. This etching operates while the gate spacer present on the sidewalls of the dummy gate is protected by the hard mask spacers.

It is to be understood that although preferred embodiments, specific constructions and configurations, as well as materials, have been discussed herein for devices according to the present invention, various changes or modifications in form and detail may be made without departing from the scope of this invention defined by the appended claims.

## Claims

1. A method comprising the steps of:
a. forming, by self-aligned multiple patterning, a first pattern of regularly spaced mandrels (4) on a layer (3) to be patterned,
b. subsequently, forming hard mask spacers (5) on sidewalls of the mandrels (4), thereby forming a second pattern formed of regularly spaced assemblies (4,5) each comprising a mandrel (4) and hard mask spacers (5) on sidewalls thereof, the hard mask spacers extending from the layer to be patterned along the sidewalls, whereby the regularly spaced assemblies (4, 5) form regularly spaced masks on the layer to be patterned, and
c. subsequently, by means of the regularly spaced masks, etching the second pattern in the layer (3) to be patterned to form a pattern of regularly spaced dummy gates.

2. The method according to claim 1, wherein the layer (3) to be patterned is a layer (3) of dummy gate material.

3. The method according to claim 2, further comprising a step d, after step c, of reducing the width of the dummy gates.

4. The method according to claim 3, further comprising a step e, after step d, of forming gate spacers (6) on sidewalls of the dummy gates.

5. The method according to claim 4, wherein step e comprises a step e1 of forming a gate spacer (6) on the sidewalls of the dummy gates and on the sidewalls of the hard mask spacers (5), and a step e2 of etching selectively the gate spacer (6) present on the sidewalls of the hard mask spacers (5) with respect to the gate spacers (6) present on the sidewalls of the dummy gates.

6. The method according to claim 4 or claim 5, wherein the layer (3) of dummy gate material is over a semiconductor fin, and wherein the method further comprises:
- a step f, after step e, of etching a part of the semiconductor fin which is not covered by the dummy gates, thereby reducing the height of the semiconductor fin, and
- a step g, after step f, of epitaxially growing a source or a drain on the etched part of the semiconductor fin.

7. The method according to claim 6, wherein the semiconductor fin is at least 70 nm high.

8. The method according to any one of the preceding claims, wherein each mandrel (4) forming the pattern has a width of at most 40 nm.

9. The method according to any one of the preceding claims, wherein the widths of the mandrels (4) are within 10% of one another, wherein the widths of the spaces between the mandrels (4) are within 10% of one another and wherein the average mandrel (4) width is within 10% of the average space width.

10. The method according to any one of the preceding claims, wherein the layer (3) to be patterned is a layer (3) of semiconductor material.

11. The method according to any one of the preceding claims, wherein the mandrels (4) comprise a bottom layer and a top layer, wherein the bottom layer is made of silicon nitride or silicon carbide and wherein the top layer is made of silicon oxide.

12. The method according to any one of the preceding claims, wherein the assemblies (4, 5) are separated by spaces and wherein the assemblies (4, 5) have an average width at least 50% larger than the width of the spaces between them.

13. The method according to any one of claims 4 to 12, wherein the material of the gate spacers (6) is different from the material of the hard mask spacers (5).

14. An intermediate structure for a formation of a Fin-based Field Effect Transistor, comprising:
- A semiconductor fin,
- A dummy gate (3');
- An assembly (4, 5) comprising a mandrel (4) having hard mask spacers (5) on sidewalls thereof, the assembly (4, 5) covering the top of the dummy gate without that the hard mask spacers (5) cover sidewalls of the dummy gate, and
wherein the width of the assembly is within 5% of the width of the dummy gate.

15. The intermediate structure according to claim 14, wherein the dummy gate has a first width measured at 10% of its height, and a second width measured at 90% of its height, and wherein the first width and the second width are within 10% of one another.

## Patentansprüche

1. Ein Verfahren, das die folgenden Schritte umfasst:
a.- Bilden, durch selbstjustierende Mehrfachstrukturierung, einer ersten Struktur aus regelmäßig beabstandeten Dornen (4) auf einer zu strukturierenden Schicht (3),
b.- anschließend Bilden von Hartmasken-Abstandshaltern (5) an Seitenwänden der Dorne (4), wodurch eine zweite Struktur gebildet wird, die aus regelmäßig beabstandeten Anordnungen (4, 5) gebildet ist, die jeweils einen Dorn (4) und Hartmasken-Abstandshalter (5) an Seitenwänden davon umfassen, wobei sich die Hartmasken-Abstandshalter von der zu strukturierenden Schicht entlang der Seitenwände erstrecken, wodurch die regelmäßig beabstandeten Anordnungen (4, 5) regelmäßig beabstandete Masken auf der zu strukturierenden Schicht bilden, und
c.- anschließend, mittels der regelmäßig beabstandeten Masken, Ätzen der zweiten Struktur in die zu strukturierende Schicht (3), um eine Struktur aus regelmäßig beabstandeten Dummy-Gates zu bilden.

2. Das Verfahren nach Anspruch 1, wobei die zu strukturierende Schicht (3) eine Schicht (3) aus Dummy-Gate-Material ist.

3. Das Verfahren nach Anspruch 2, das nach Schritt c weiter einen Schritt d des Reduzierens der Breite der Dummy-Gates umfasst.

4. Das Verfahren nach Anspruch 3, das nach Schritt d weiter einen Schritt e des Bildens von Gate-Abstandshaltern (6) an Seitenwänden der Dummy-Gates umfasst.

5. Das Verfahren nach Anspruch 4, wobei Schritt e einen Schritt e1 des Bildens eines Gate-Abstandshalters (6) an den Seitenwänden der Dummy-Gates und an den Seitenwänden der Hartmasken-Abstandshalter (5), und einen Schritt e2 des selektiven Ätzens des an den Seitenwänden der Hartmasken-Abstandshalter (5) vorhandenen Gate-Abstandshalters (6) in Bezug auf die an den Seitenwänden der Dummy-Gates vorhandenen Gate-Abstandshalter (6) umfasst.

6. Das Verfahren nach Anspruch 4 oder Anspruch 5, wobei die Schicht (3) aus Dummy-Gate-Material über einer Halbleiterrippe liegt und wobei das Verfahren weiter umfasst:
- nach Schritt e einen Schritt f des Ätzens eines Teils der Halbleiterrippe, der nicht von den Dummy-Gates bedeckt ist, wodurch die Höhe der Halbleiterrippe reduziert wird, und
- nach Schritt f einen Schritt g des epitaktischen Aufwachsens einer Source oder eines Drains auf dem geätzten Teil der Halbleiterrippe.

7. Das Verfahren nach Anspruch 6, wobei die Halbleiterrippe mindestens 70 nm hoch ist.

8. Das Verfahren nach einem der vorstehenden Ansprüche, wobei jeder Dorn (4), der die Struktur bildet, eine Breite von höchstens 40 nm aufweist.

9. Das Verfahren nach einem der vorstehenden Ansprüche, wobei die Breiten der Dorne (4) innerhalb von 10 % voneinander liegen, wobei die Breiten der Abstände zwischen den Dornen (4) innerhalb von 10 % voneinander liegen und wobei die durchschnittliche Breite eines Dorns (4) innerhalb von 10 % der durchschnittlichen Abstandsbreite liegt.

10. Das Verfahren nach einem der vorstehenden Ansprüche, wobei die zu strukturierende Schicht (3) eine Schicht (3) aus Halbleitermaterial ist.

11. Das Verfahren nach einem der vorstehenden Ansprüche, wobei die Dorne (4) eine untere Schicht und eine obere Schicht umfassen, wobei die untere Schicht aus Siliziumnitrid oder Siliziumkarbid besteht und wobei die obere Schicht aus Siliziumoxid besteht.

12. Das Verfahren nach einem der vorstehenden Ansprüche, wobei die Anordnungen (4, 5) durch Abstände getrennt sind und wobei die Anordnungen (4, 5) eine durchschnittliche Breite aufweisen, die mindestens 50 % größer ist als die Breite der Abstände zwischen ihnen.

13. Das Verfahren nach einem der Ansprüche 4 bis 12, wobei sich das Material der Gate-Abstandshalter (6) vom Material der Hartmasken-Abstandshalter (5) unterscheidet.

14. Eine Zwischenstruktur für eine Bildung eines Feldeffekttransistors auf Basis von Rippen, umfassend:
- eine Halbleiterrippe,
- ein Dummy-Gate (3');
- eine Anordnung (4, 5), die einen Dorn (4) umfasst, der an Seitenwänden davon Hartmasken-Abstandshalter (5) aufweist, wobei die Anordnung (4, 5) die Oberseite des Dummy-Gates bedeckt, ohne dass die Hartmasken-Abstandshalter (5) Seitenwände des Dummy-Gates bedecken, und
wobei die Breite der Anordnung innerhalb von 5 % der Breite des Dummy-Gates liegt.

15. Die Zwischenstruktur nach Anspruch 14, wobei das Dummy-Gate eine erste Breite, bei 10 % seiner Höhe gemessen, und eine zweite Breite, bei 90 % seiner Höhe gemessen, aufweist, und wobei die erste Breite und die zweite Breite innerhalb von 10 % voneinander liegen.

## Revendications

1. Un procédé comprenant les étapes de :
a. former, par auto-alignement de multiples motifs, un premier motif de mandrins (4) régulièrement espacés sur une couche (3) à structurer,
b. former ensuite des espaceurs de masque dur (5) sur les parois latérales des mandrins (4), formant ainsi un second motif constitué d'assemblages (4,5) régulièrement espacés, chaque assemblage comprenant un mandrin (4) et des espaceurs de masque dur (5) sur ses parois latérales, les espaceurs de masque dur s'étendant de la couche à structurer le long des parois latérales, de sorte que les assemblages (4, 5) régulièrement espacés forment des masques régulièrement espacés sur la couche à structurer, et
c. ensuite, au moyen des masques régulièrement espacés, graver le second motif dans la couche (3) à structurer pour former un motif de grilles fictives régulièrement espacées.

2. Le procédé selon la revendication 1, dans lequel la couche (3) à structurer est une couche (3) de matériau de grille fictive.

3. Le procédé selon la revendication 2, comprenant en outre une étape d, après l'étape c, de réduction de la largeur des grilles fictives.

4. Le procédé selon la revendication 3, comprenant en outre une étape e, après l'étape d, de formation d'espaceurs de grille (6) sur les parois latérales des grilles fictives.

5. Le procédé selon la revendication 4, dans lequel l'étape e comprend une étape e1 de formation d'un espaceur de grille (6) sur les parois latérales des grilles fictives et sur les parois latérales des espaceurs de masque dur (5), et une étape e2 de gravure sélective de l'espaceur de grille (6) présent sur les parois latérales des espaceurs de masque dur (5) par rapport aux espaceurs de grille (6) présents sur les parois latérales des grilles fictives.

6. Le procédé selon la revendication 4 ou 5, dans lequel la couche (3) de matériau de grille fictive est sur une ailette de semi-conducteur, et dans lequel le procédé comprend en outre :
- une étape f, après l'étape e, de gravure d'une partie de l'ailette de semi-conducteur qui n'est pas couverte par les grilles fictives, réduisant ainsi la hauteur de l'ailette de semi-conducteur, et
- une étape g, après l'étape f, de croissance épitaxiale d'une source ou d'un drain sur la partie gravée de l'ailette de semi-conducteur.

7. Le procédé selon la revendication 6, dans lequel l'ailette de semi-conducteur a une hauteur d'au moins 70 nm.

8. Le procédé selon l'une quelconque des revendications précédentes, dans lequel chaque mandrin (4) formant le motif a une largeur d'au plus 40 nm.

9. Le procédé selon l'une quelconque des revendications précédentes, dans lequel les largeurs des mandrins (4) sont dans une tolérance de 10 % les unes par rapport aux autres, dans lequel les largeurs des espaces entre les mandrins (4) sont dans une tolérance de 10 % les unes par rapport aux autres et dans lequel la largeur moyenne des mandrins (4) est dans une tolérance de 10 % de la largeur moyenne des espaces.

10. Le procédé selon l'une quelconque des revendications précédentes, dans lequel la couche (3) à structurer est une couche (3) de matériau semi-conducteur.

11. Le procédé selon l'une quelconque des revendications précédentes, dans lequel les mandrins (4) comprennent une couche inférieure et une couche supérieure, dans lequel la couche inférieure est en nitrure de silicium ou en carbure de silicium et dans lequel la couche supérieure est en oxyde de silicium.

12. Le procédé selon l'une quelconque des revendications précédentes, dans lequel les assemblages (4, 5) sont séparés par des espaces et dans lequel les assemblages (4, 5) ont une largeur moyenne au moins 50 % plus grande que la largeur des espaces entre eux.

13. Le procédé selon l'une quelconque des revendications 4 à 12, dans lequel le matériau des espaceurs de grille (6) est différent du matériau des espaceurs de masque dur (5).

14. Une structure intermédiaire pour la formation d'un transistor à effet de champ basé sur une ailette, comprenant :
- Une ailette de semi-conducteur,
- Une grille fictive (3');
- Un assemblage (4, 5) comprenant un mandrin (4) ayant des espaceurs de masque dur (5) sur ses parois latérales, l'assemblage (4, 5) couvrant le dessus de la grille fictive sans que les espaceurs de masque dur (5) couvrent les parois latérales de la grille fictive, et
dans lequel la largeur de l'assemblage est dans une tolérance de 5 % de la largeur de la grille fictive.

15. La structure intermédiaire selon la revendication 14, dans laquelle la grille fictive a une première largeur mesurée à 10 % de sa hauteur, et une seconde largeur mesurée à 90 % de sa hauteur, et dans laquelle la première largeur et la seconde largeur sont dans une tolérance de 10 % l'une par rapport à l'autre.
